# EUROPEAN PATENT SPECIFICATION

(11) **EP 1 589 129 B1**
(45) Date of publication and mention of the grant of the patent: **14.02.2007**
(21) Application number: 04257825.2
(22) Date of filing: 16.12.2004
(51) Int. Cl.: C23C 14/34

(54) **Controlled cooling of sputter targets**
Kontrollierte Abkühlung von Zerstaubungstarget
Refroidissement controllé de cibles de pulvérisation

(30) Priority: 23.04.2004 US 829952
(43) Date of publication of application: 26.10.2005
(73) Proprietor: Heraeus Inc, Chandler, AZ 85226 (US)
(72) Inventor: Cheng, Yuanda R., Phoenix AZ 85048 (US); Racine, Michael Gene, Phoenix AZ 85044 (US); Kennedy, Steve Roger, Chandler AZ 85226 (US); Deodutt, Anand S., Gilbert AZ 85233 (US)
(74) Representative: Hill, Justin John

(56) References cited:
- WO-A-00/15863
- WO-A-00/22185
- WO-A-02/22300
- US-A- 5 269 899
- US-A- 6 071 389
- US-B1- 6 340 415
- PATENT ABSTRACTS OF JAPAN vol. 013, no. 190 (C-593), 8 May 1989 (1989-05-08) & JP 01 017862 A (FUJITSU LTD), 20 January 1989 (1989-01-20)

## Description

### FIELD OF THE INVENTION

The present invention relates generally to the field of sputter targets and, more particularly, relates to controlled cooling of sputter targets through surface area alteration.

### DESCRIPTION OF THE RELATED ART

The process of sputtering is widely used in a variety of fields to provide thin film material deposition of a precisely controlled thickness with an atomically smooth surface, for example to coat semiconductors and/or to form films on surfaces of magnetic recording media. In the sputtering process, a sputter target is positioned in a chamber filled with an inert gas atmosphere, and is exposed to an electric field to generate a plasma. Ions within this plasma collide with a surface of the sputter target causing the sputter target to emit atoms from the sputter target surface. The voltage difference between the sputter target and the substrate that is to be coated causes the emitted atoms to form the desired film on the surface of the substrate.

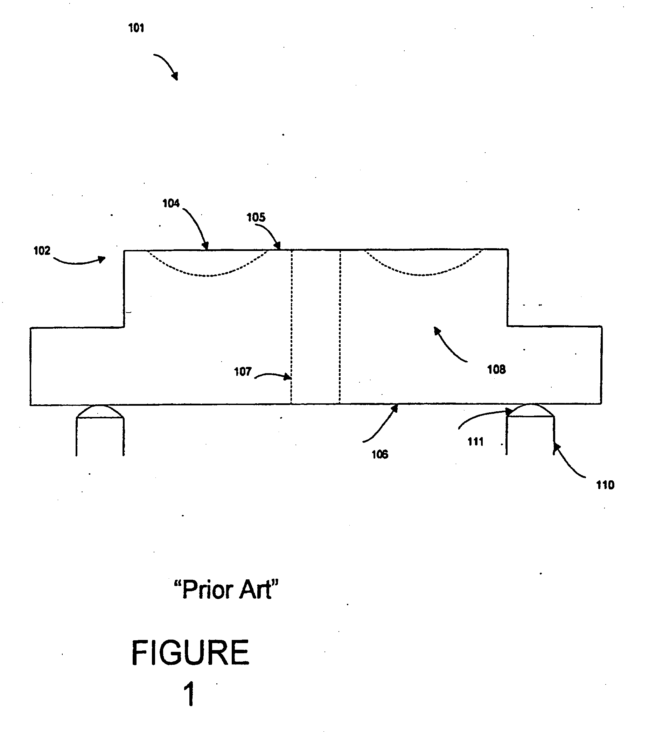

During sputtering, heat often builds up on the sputter target, negatively affecting control of the sputter process and shortening the lifetime of the sputter target. Figure 1 depicts an example of one such conventional sputter target. Specifically, conventional sputter target 101 includes sputter surface 102, where sputter surface 102 includes sputter area 104 for sputtering, and non-sputter area 105. Conventional sputter target 101 also includes backside surface 106, and hole 107 drilled through conventional sputter target 101, for holding sputter target 101 in place while sputtering.

Conventional sputter target 101 is placed in a vacuum chamber, and clamped onto ring-shaped support 110. An air-tight and water-tight seal is created between gasket 111 and backside surface 106. A cooling fluid such as water is pumped into the cavity created by ring-shaped support 110, and the cooling fluid dissipates heat generated on sputter surface 102. After prolonged sputtering, sputter area 104 erodes or wears down as atoms of sputter target 101 are emitted from sputter surface 102. This erosion causes grooves to be formed on sputter surface 102, illustrated with dashed lines.

Success in the sputter coating of thin-film materials, especially sputter coating of thin films in the magnetic data storage industry, is highly dependent on effective heat dissipation. Specifically, high temperatures on a sputter target increase the rate at which sputtering occurs, and affect the uniformity of thin-film deposition. If sputtering occurs too quickly, the useful life of a particular sputter target will decrease, resulting in higher replacement costs and more frequent system downtimes. Moreover, if the sputter target gets too hot, the bond between the different materials comprising the sputter target can melt, degrading the efficiency of the sputtering process and causing unnecessary interruptions to the sputtering process.

Conventional sputter targets do not have enhanced or selective control over the cooling of the sputter target, other than by modifying sputtering equipment or by selecting backing materials with desirable heat retention properties. Accordingly, it is desirable to provide a method for controlling the cooling of sputter targets during sputtering. In particular, it is desirable to provide a method for selectively controlling the cooling of specific locations on the major surface of a sputtering target by surface area alteration of the backside surface, in order to improve sputtering safety and efficacy.

### SUMMARY OF THE INVENTION

The buildup of heat is an inherent side-effect of the sputtering process. Too much heat can negatively affect the life-cycle of a sputter target, and degrade uniformity of thin-film deposition. In this regard, an embodiment of the invention addresses disadvantages found in conventional sputter targets, particularly with regard to those disadvantages which relate to the buildup of heat on a sputter target during sputtering.

In one aspect of the invention, a sputter target in which cooling rates are selectively controlled through surface area alteration is manufactured by generating a sputter surface and a backside surface obverse to the sputter surface. The backside surface includes at least a first textured region, where the first textured region aids in cooling a region of the sputter target adjacent to the first textured region, by effectuating heat dissipation.

By manipulating the surface area of a textured region, the cooling rate at specific areas of a sputter target can be controlled, and the wear pattern of the sputter area can be controlled. For example, by increasing the cooling rate at selected locations on a sputter target, the sputtering process can be slowed down, resulting in an extended service life for a particular sputter target, and reduced operating costs. By including more than one textured region, the sputtering rate can be adjusted or tuned to different rates at selected locations on the surface of the sputter target, further enhancing control over the sputtering process.

The backside surface also includes at least a first non-textured region. By placing a non-textured region on the backside surface of the sputter target, cooling rates can be decreased or left alone at other locations. Non-textured regions may be located on an obverse surface to non-sputter areas on the sputter surface, which are often cooler than sputter areas and consequently wear at a slower pace. Furthermore, a non-textured region could be placed adjacent to a vacuum seal gasket in order to effectuate a vacuum seal and prevent a gas-liquid exchange from occurring between the cooling fluid and the vacuum chamber.

The first textured region is generated using grit blasting, random machining, laser ablation, or using a lathe. Each of these texturing methods provides for a textured backside region with an increased surface area over a polished backside region. The increase in surface area allows greater contact to the cooling fluid applied to the first textured region, increasing the cooling rate of the sputter target at a location obverse to the first textured region.

In a second aspect the present invention is a sputter target in which cooling rates are selectively controlled. The sputtering target includes a sputter surface and a backside surface obverse to the sputter surface, where the backside surface further includes at least a first textured region. The backside surface further includes at least a first non-textured region.

The textured region aids in cooling a region of the sputter target adjacent to the textured region, by effectuating heat dissipation. Texturing the backside surface of the sputter target allows for greater contact with cooling fluids, increasing heat dissipation. The sputter target may be circular, rectangular, or hexagonal.

While sputtering, the intense heat develops in the sputter target, due to the collisions betweens ions and atoms of target material in the sputter area. As a consequence of the rising temperature, the rate in which sputtering occurs increases, further increasing the amount of target material ejected from the sputter area. This, in turn, causes increased wear on the sputter area, shortening the usable life of the sputter target.

By placing the textured region obverse to the sputter area, heat is dissipated from the textured region at an increased rate, selectively cooling the sputter area. Controlling the cooling rate of the sputter area through alteration of the surface area of the backside surface allows the sputter area to be cooled faster, slower, or at the same rate as the non-sputter areas of the sputter target.

In an alternative arrangement, the sputter surface further includes a sputter area for sputtering and at least a first non-sputter area, and the textured region is obverse to the non-sputter area. The sputter rate can be controlled at any selected area across the entire sputter surface, not just at the sputter area.

The sputter target is comprised of a either a metal alloy or a ceramic material, although an embodiment of the present invention will impact materials with high thermal conductivity, such as metals, more than those with a lower thermal conductivity, such as ceramics.

The textured region either protrudes from the backside surface or cuts into the backside surface. Moreover, the textured region is textured with a random texture, such as grit blasting or random machining.

In the case where a sputter target is directly cooled by contact with a chilled fluid on the backside surface, the cooling rate of the sputter target depends on the thermal conductivity of the sputter target. Since the cooling fluid is rapidly flowing over the backside surface, the cooling fluid is itself not being heated to any marked extent. As such, by increasing the surface area of the backside surface, contact between the cooling fluid and the sputter target increases, increasing the amount of heat dissipated into the cooling fluid in a given time interval.

The textured region may alternatively be textured with cross-hatches, concentric circles, rectangular shapes, parallel lines or curved lines, where the curved lines facilitate rapid flow or turbulent flow of a cooling fluid which is in contact with the backside surface. Curved lines can create channels, facilitating rapid flow of the cooling fluid from a fluid inlet to a fluid outlet, or the curved lines can create rough spots perpendicular to the direction of flow of the cooling fluid, facilitating turbulent flow.

In a third aspect, the present invention is a sputter target assembly in which cooling rates are selectively controlled through surface area alteration. The sputter target assembly includes a sputter target, where the sputter target further includes a sputter surface, and a backing plate, where the backing plate further includes a backside surface. The backside surface further includes at least a first textured region. The sputter target and the backing plate are bonded together, so that the sputter surface is obverse to the backside surface. The textured region aids in cooling a region of the sputter target assembly adjacent to the textured region, by effectuating heat dissipation.

Typically, sputter targets are bonded to backing plates in order to enhance the effect of the cooling fluid. The sputter surface is generated on a sputter target and the backside surface can be generated on a backing plate in order to increase the surface area of the backing plate and, consequently, the overall sputter target assembly. The sputter target and the backing plate are bonded together prior to or after the generation of the sputter surface or the backside surface.

In a fourth aspect, the present invention is a method for manufacturing a sputter target assembly in which cooling rates are selectively controlled through surface area alteration. The method includes the steps of generating a sputter surface on a sputter target, and generating a backside surface on a backing plate, where the backside surface includes at least a first textured region. The method also includes the step of bonding the sputter target and the backing plate together, so that the sputter surface is obverse to the backside surface. The first textured region aids in cooling a region of the sputter target assembly adjacent to the first textured region, by effectuating heat dissipation.

In the following description of the preferred embodiment, reference is made to the accompanying drawings that form a part thereof, and in which is shown by way of illustration a specific embodiment in which the invention may be practiced. It is to be understood that other embodiments may be utilized and changes may be made without departing from the scope of the present invention.

### BRIEF DESCRIPTION OF THE DRAWINGS

Referring now to the drawings in which like reference numbers represent corresponding parts throughout:
Figure 1 depicts an example of a conventional sputter target;
Figure 2 depicts the external appearance of one embodiment of the present invention;
Figure 3 depicts examples of the textured region on a circular sputter target;
Figure 4 depicts an example of the textured region on a rectangular sputter target;
Figure 5 is a close-up illustration of the textured region, using three possible texture patterns;
Figures 6A and 6B illustrate the spatial relationship between a sputter target having a textured region with a curved line texture, and the flow of a cooling liquid;
Figure 7 depicts an example sputter surface and backside surface, according to the Figure 2 embodiment;
Figure 8 depicts an additional example of a sputter surface and a backside surface, according to a preferred embodiment of the present invention;
Figure 9 is a flow chart depicting the process for manufacturing a sputter target in which cooling rates are selectively controlled through surface area alteration;
Figure 10 depicts an example of an external appearance of a second embodiment of the present invention; and
Figure 11 is a flow chart depicting the process for manufacturing a sputter target assembly in which cooling rates are selectively controlled through surface area alteration.

### DETAILED DESCRIPTION

Embodiments of the present invention allow for improved control over the cooling of a sputter target and for extending the useful life of a sputter target, by controlling the cooling of the sputter target at selected areas through surface area alteration.

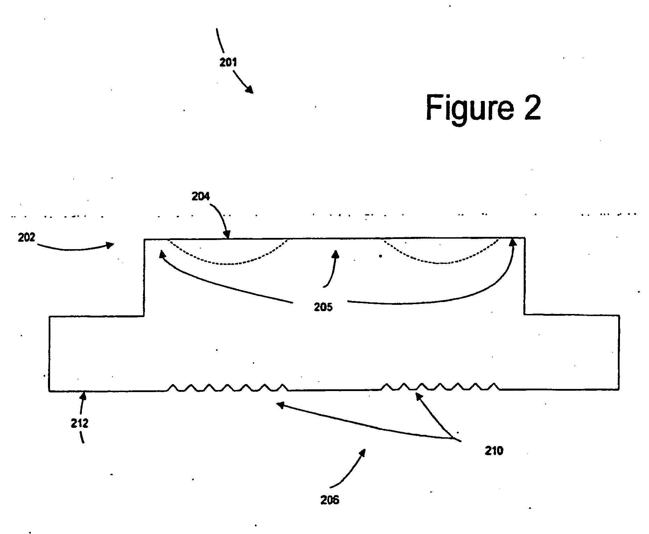

Figure 2 depicts the external appearance of a sputter target according to an embodiment of the present invention. Briefly, an embodiment of the present invention relates to a sputter target in which cooling rates are selectively controlled through surface area alteration. The sputter target includes a sputter surface and a backside surface obverse to the sputter surface, where the backside surface further includes at least one textured region. The textured region aids in cooling a region of the sputter target adjacent to the textured region, by effectuating heat dissipation.

In more detail, sputter target 201 includes sputter surface 202, where sputter surface 202 further includes sputter area 204 for sputtering, and non-sputter areas 205. Sputter target 201 also includes backside surface 206 obverse to sputter surface 202.

Backside surface 206 includes textured regions 210. Textured regions 210 aids in cooling a region of sputter target 201 adjacent to textured regions 210 through heat dissipation. Backside surface 206 also includes at least non-textured region 212. In an alternate arrangement, non-textured region 212 is omitted, and textured regions 210 covers the entire surface of backside surface 206.

Sputter target 201 is comprised of a metal alloy and/or a ceramic material, and can be of any shape, including but not limited to circular, rectangular, or hexagonal shape. An embodiment of the present invention will impact materials with high thermal conductivity, such as metals, more than those with a lower thermal conductivity, such as ceramics.

Prior to sputtering, sputter target 201 is placed in a vacuum chamber, and clamped onto a ring-shaped support (not depicted). An air-tight and water-tight seal is created between a gasket (not depicted) on top of the ring-shaped or rectangular-shaped support, and backside surface 206. A cooling fluid such as water is pumped into the cavity created by the support, and the cooling fluid absorbs the dissipated heat which is generated on sputter surface 202.

Textured regions 210 can be textured with many different texture shapes, including but not limited to concentric circles, cross hatches, rectangular shapes, parallel lines, curved lines and/or random textures, such as grit blasting or random machining. Curved lines on textured regions 210 can facilitate rapid flow or turbulent flow of a cooling fluid which is in contact with the backside surface. Textured regions 210 can protrude from and/or cut into backside surface.

Each of these texturing methods provides for a textured backside region with an increased surface area over a polished backside region. The increase in surface area allows greater contact to the cooling fluid applied to textured regions 210, increasing the cooling rate of the sputter target at a location obverse to textured regions 210.

By placing a non-textured region on the backside surface of the sputter target, cooling rates can be decreased or left alone at selected locations. Non-textured regions may be located on an obverse surface to non-sputter areas on the sputter surface, which are often cooler than sputter areas, and consequently wear at a slower pace. Moreover, a non-textured region could be placed adjacent to a vacuum seal gasket in order to effectuate a vacuum seal and prevent a gas-liquid exchange from occurring between the cooling fluid and the vacuum chamber.

By manipulating the surface area of a textured region, the cooling rate at specific areas of a sputter target can be selectively controlled. By increasing the cooling rate at selected locations on a sputter target, heat dissipates faster, and the sputtering process slows. As a result, the useful life of a particular sputter target is extended, and operating costs are reduced.

Textured regions 210 is obverse to sputter area 204. In an alternate arrangement, textured regions 210 is obverse to non-sputter areas 205. It is advantageous to locate non-textured regions obverse to non-sputter areas on the sputter surface, which are often cooler than sputter areas, and which typically wear at a slower pace.

The sputter area is the hottest portion of sputter surface 202 because of the collisions betweens ions in the plasma and atoms on the sputter target. The sputtering rate increase as temperatures increase, causing increased wear on the sputter area. By placing the textured region obverse to the sputter area, heat can be quickly dissipated from the textured region, selectively cooling the sputter area, and decreasing wear. By locating the textured region obverse to the sputter area, the cooling rate of the sputter area can be fine-tuned, allowing the sputter area to be cooled faster, slower, or at the same rate as the non-sputter areas of the sputter target.

In the case where a sputter target is directly cooled by contact with a chilled fluid on the backside surface, the cooling rate of the sputter target depends on the thermal conductivity of the sputter target. Since the cooling fluid is rapidly flowing over the backside surface, the cooling fluid is itself not being heated to any marked extent. As such, by increasing the surface area of the backside surface, contact between the cooling fluid and the sputter target increases, therefore increasing the amount of heat dissipated into the cooling fluid per unit time.

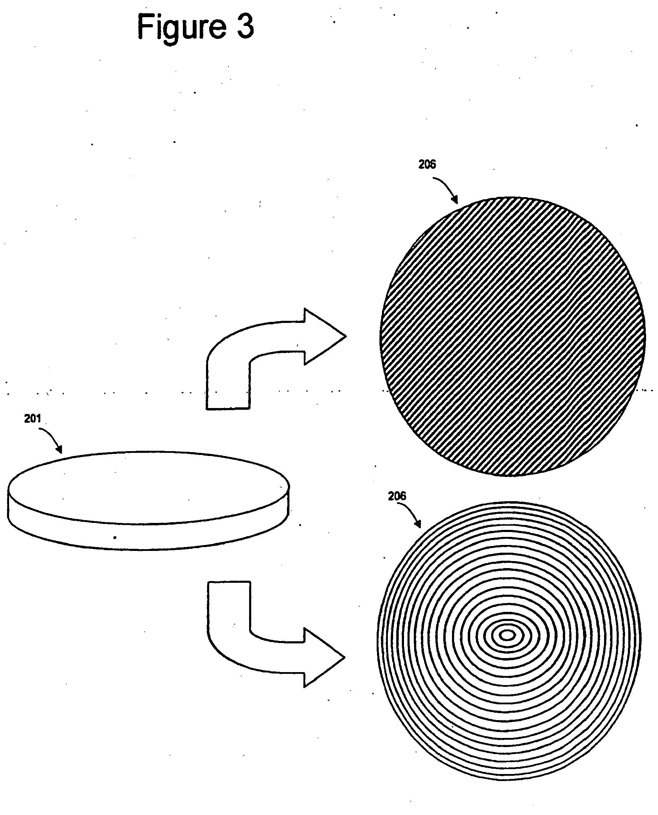

Figure 3 depicts examples of the textured region on a circular sputter target. Specifically, Figure 3 illustrates circle-shaped sputter target 201 with backside surface 206 having either a parallel line texture region, or a concentric oval texture region. In both illustrated examples, textured regions 210 covers the entirety of backside surface 206.

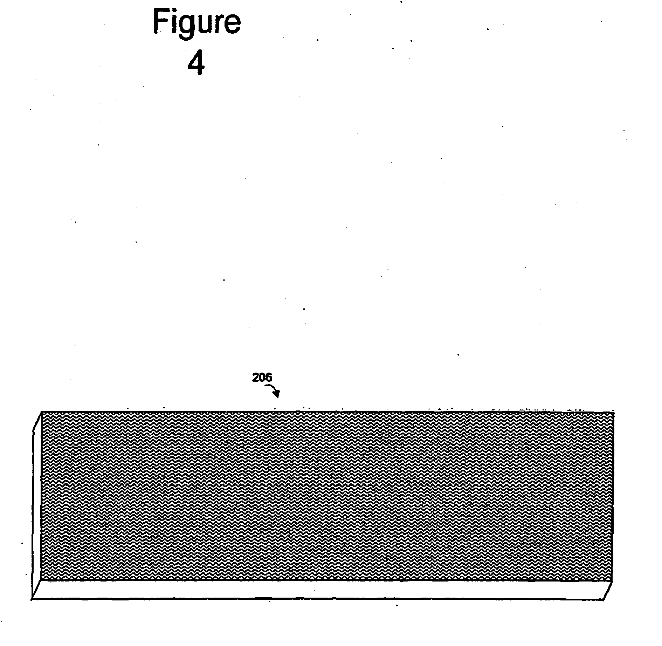

Figure 4 depicts an example of the textured region on a rectangular sputter target. Specifically, Figure 4 illustrates rectangular-shaped sputter target 201 with backside surface 206, where textured regions 210 has parallel, curved lines. Textured regions 210 covers the entirety of backside surface 206.

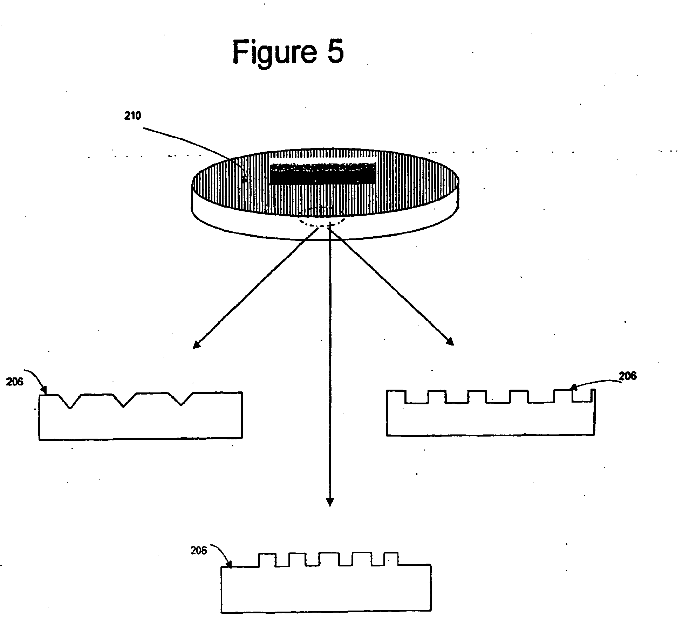

Figure 5 is a close-up illustration of the textured region, using three possible texture patterns. In particular, Figure 5 depicts a side profile of backside surface 206, in order to demonstrate the height or depth texturing, with respect to a non-textured region on backside surface 206. In the case where textured region 210 is textured using a cutting device such as a lathe or a laser cutting tool, the cross-sectional shape of a cut can be triangle shape, rectangular shape, or arc shape (not depicted). Furthermore, textured regions 210 can protrude from and/or cut into backside surface 206.

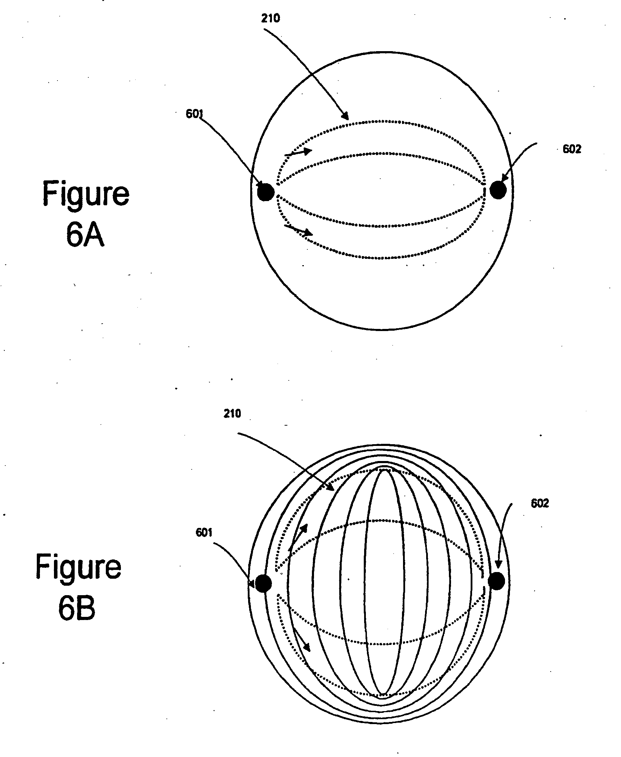

Figures 6A and 6B illustrate the spatial relationship between a curved line textured region on a sputter target, and the flow of a cooling liquid. Specifically in Figure 6A round sputter target 201 has been mounted in a vacuum chamber, as described more fully above. Cooling fluid, which is applied to backside surface 206, enters a chamber under sputter target 201 via fluid inlet 601, and drains from the chamber under sputter target 201 via fluid outlet 602. As depicted in Figures 6A and 6B, cooling fluid generally flows in a right-to-left direction underneath sputter target 201, from fluid inlet 601 to fluid outlet 602.

Textured regions 210 can be used to facilitate rapid flow or turbulent flow of the cooling fluid. In Figure 6A, textured regions 210 is textured with curved lines, where the curved lines are generally parallel to the flow of the cooling fluid, and where the curved lines emanate and terminate from an area above fluid inlet 601 and fluid outlet 602. As such, textured regions 210 creates channels in which the cooling fluid can flow, facilitating smooth, rapid flow of the cooling fluid from fluid inlet 601 to fluid outlet 602.

In Figure 6B, textured regions 210 is textured with curved lines, where the curved lines are generally perpendicular to the flow of the cooling fluid. In this regard, textured regions 210 creates rough spots on backside surface 206 in which channels of cooling fluid are not formed, facilitating the turbulent flow of the cooling fluid which is in contact with backside surface 206.

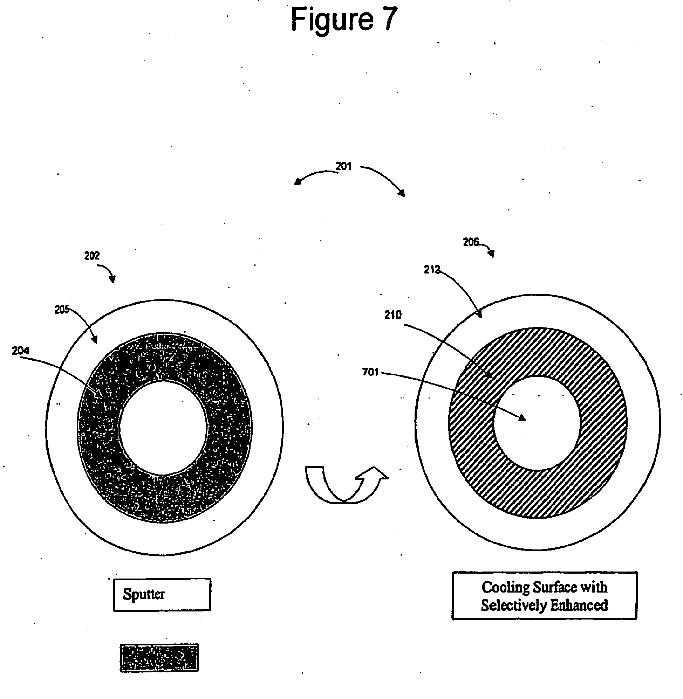

Figure 7 depicts an example sputter surface and backside surface, according to the Figure 2 embodiment. Figure 7 illustrates a top view and a bottom view of sputter target 201, showing sputter surface 202, where sputter surface 202 further includes sputter area 204 for sputtering, and non-sputter areas 205. Sputter target 201 also includes backside surface 206 obverse to sputter surface 202, where backside surface 206 includes textured regions 210, non-textured region 212, and second non-textured region 701.

Textured regions 210 is obverse to sputter area 204. As such, textured regions 210 aids in cooling a region of sputter target 201 adjacent to textured regions 210 through heat dissipation. By placing textured regions 210 obverse to the sputter area, heat which has built up at sputter area 204 can be quickly dissipated, selectively cooling sputter area 204, and decreasing overall wear on sputter target 201. By locating textured regions 210 obverse to sputter area 204, the cooling rate of sputter area 204 can be fine-tuned, allowing sputter area 204 to be cooled faster, slower, or at the same rate as the non-sputter areas of sputter target 201.

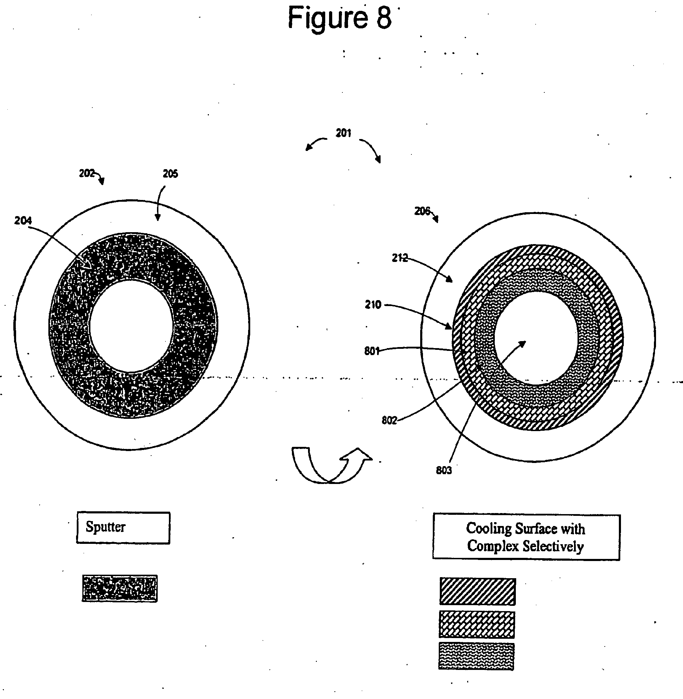

Figure 8 depicts other embodiments of a sputter surface and a backside surface, according to a preferred embodiment of the present invention. Specifically, Figure 8 illustrates an additional top and bottom view of sputter target 201, illustrating sputter surface 202, where sputter surface 202 further includes sputter area 204 for sputtering, and non-sputter areas 205. Sputter target 201 also includes backside surface 206 obverse to sputter surface 202, where backside surface 206 includes first textured regions 210, second textured region 801, third textured region 802, non-textured region 212, and second non-textured region 803.

Combined, first textured regions 210, second textured region 801, and third textured region 802 are obverse to sputter area 204. As was the case with the Figure 7 arrangement, heat which has built up at sputter area 204 can be quickly dissipated by texturing the area obverse to sputter area 204, extending the usable life of sputter target 201. In Figure 8, however, a plurality of different textures have been applied to backside surface 206, where each textured region has a discrete, known cooling rate. In this regard, the respective selected areas adjacent to first textured regions 210, second textured region 801, and third textured region 802 cool at different rates, causing sputtering to occur at different rates within the sputter area. In this regard, the cooling rate of sputter area 204 is fine-tuned, allowing selected portions of sputter area 204 to be cooled faster, slower, or at the same rate as the non-sputter areas of sputter target 201 or different areas within sputter area 204.

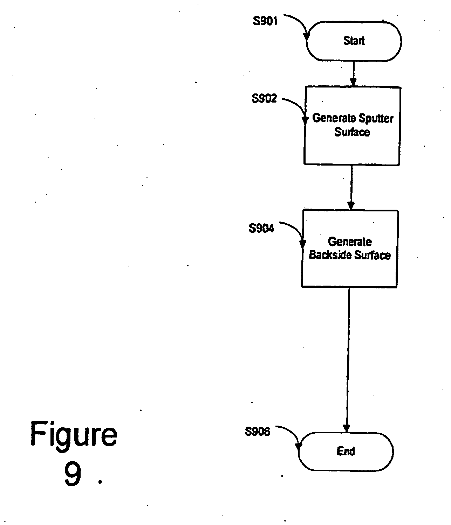

Figure 9 is a flow chart depicting the process for manufacturing a sputter target in which cooling rates are selectively controlled through surface area alteration, according to an additional aspect of the present invention. Briefly, a sputter surface is generated, and a backside surface is generated obverse to the sputter surface, where the backside surface includes at least a first textured region. The first textured region aids in cooling a region of the sputter target adjacent to the first textured region, by effectuating heat dissipation.

In more detail, the process begins (step S901), and a sputter surface is generated (step S902). The sputter target is generated on two different target materials, where a sputter target assembly is clamped or bonded to a backing plate, in order to enhance the cooling effect of a cooling fluid. As such, the sputter surface is generated on a first material, where the sputter surface includes a sputter area for sputtering, and at least a first non-sputter area. The process of generating a sputter surface on a sputter target is well known in the material science art.

A backside surface is generated (step S904). The backside surface is generated on a second material, such as a backing plate, in order to increase the surface area of the backing plate and the overall target assembly. The backside surface includes at least a first textured region, where the first textured region aids in cooling a region of the sputter target adjacent to the first textured region, by effectuating heat dissipation. The backside surface also includes at least a first non-textured region.

By manipulating the surface area of a textured region, the cooling rate at specific areas of a sputter target can be controlled, and the wear pattern of the sputter area can controlled. By increasing the cooling rate at selected locations on a sputter target, the sputtering process can be slowed down, resulting in an extended service life for a particular sputter target, and reduced operating costs. By including more than one textured region, the sputtering rate can be adjusted or tuned to different rates at selected locations on the surface of the sputter target, further enhancing control over the sputtering process.

The first textured region is generated using a process such as grit blasting or random machining, laser ablation, or using a lathe. The first textured region can be textured with many different texture shapes, including but not limited to concentric circles or ovals, cross-hatches, rectangular shapes, parallel lines, curved lines, and/or random textures. Curved lines on the first textured region can facilitate rapid flow or turbulent flow of a cooling fluid which is in contact with the backside surface. The first textured region can protrude from and/or cut into the backside surface.

Each of these texturing methods provides for a textured backside region with an increased surface area over a polished backside region. The increase in surface area allows greater contact to the cooling fluid applied to the first textured region, increasing the cooling rate of the sputter target at a location obverse to the first textured region.

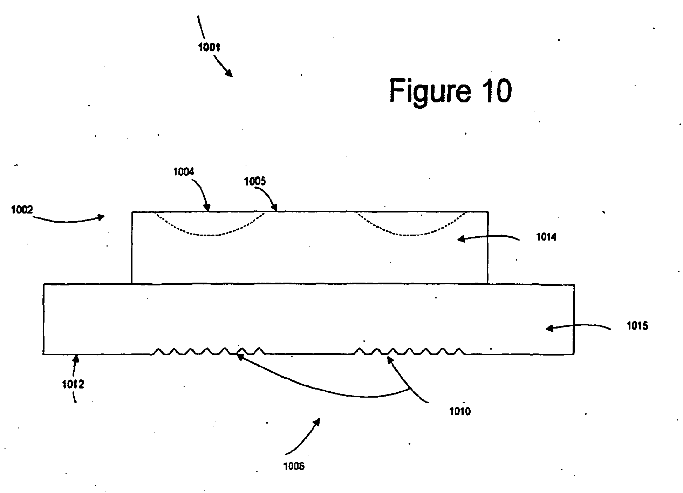

Figure 10 depicts the external appearance of a third embodiment of the present invention. Briefly, an embodiment of the present invention relates to a sputter target assembly in which cooling rates are selectively controlled through surface area alteration. The sputter target assembly includes a sputter target, where the sputter target further includes a sputter surface, and a backing plate, where the backing plate further includes a backside surface. The backside surface further includes at least a first textured region. The sputter target and the backing plate are bonded together, so that the sputter surface is obverse to the backside surface. The first textured region aids in cooling a region of the sputter target assembly adjacent to the first textured region, by effectuating heat dissipation.

Typically, sputter targets are bonded to backing plates in order to enhance the effect of the cooling fluid. The sputter surface is generated on a sputter target and the backside surface can be generated on a backing plate in order to increase the surface area of the backing plate and, consequently, the overall sputter target assembly. The sputter target and the backing plate are bonded together prior to or after the generation of the sputter surface or the backside surface.

In more detail, sputter target assembly 1001 includes sputter target 1014, where sputter target 1014 includes sputter surface 1002. Sputter surface 1002 further includes sputter area 1004 for sputtering, and first non-sputter area 1005. Sputter target assembly 1001 also includes backing plate 1015, where backing plate 1015 further includes backside surface 1006. Sputter target 1014 and backing plate 1015 are bonded together, so that sputter surface 1002 is obverse to backside surface 1006.

Backside surface 1006 includes textured region 1010. Textured region 1010 aids in cooling a region of sputter target assembly 1001 adjacent to textured region 1010 through heat dissipation. Backside surface 1006 also includes at least first non-textured region 1012. In an alternate arrangement, first non-textured region 1012 is omitted, and textured region 1010 covers the entire surface of backside surface 1006.

Sputter target 1014 is comprised of a metal alloy and/or a ceramic material, and can be of any shape, including but not limited to circular, rectangular, or hexagonal shape. An embodiment of the present invention will impact materials with high thermal conductivity, such as metals, more than those with a lower thermal conductivity, such as ceramics.

Prior to sputtering, sputter target assembly 1001 is placed in a vacuum chamber, and clamped onto a ring-shaped support (not depicted). An air-tight and water-tight seal is created between a gasket (not depicted) on top of the ring-shaped or rectangular-shaped support, and backside surface 1006. A cooling fluid such as water is pumped into the cavity created by the support, and the cooling fluid absorbs the dissipated heat which is generated on sputter surface 1002.

Textured region 1010 can be textured with many different texture shapes, including but not limited to concentric circles, cross hatches, rectangular shapes, parallel lines, curved lines and/or random textures, such as grit blasting or random machining. Curved lines on textured region 1010 can facilitate rapid flow or turbulent flow of a cooling fluid which is in contact with the backside surface. Textured region 1010 can protrude from and/or cut into backside surface.

Textured region 1010 is obverse to sputter area 1004. In an alternate arrangement, textured region 1010 is obverse to first non-sputter area 1005. It is advantageous to locate non-textured regions obverse to non-sputter areas on the sputter surface, which are often cooler than sputter areas, and which typically wear at a slower pace.

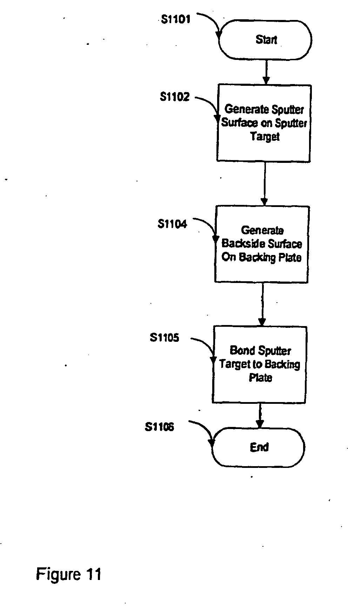

Figure 11 is a flow chart depicting the process for manufacturing a sputter target assembly in which cooling rates are selectively controlled through surface area alteration, according to an additional aspect of the present invention. Briefly, a sputter surface is generated on a sputter target, and a backside surface is generated on a backing plate, where the backside surface includes at least a first textured region. The sputter target and the backing plate are bonded together, so that the sputter surface is obverse to the backside surface. The first textured region aids in cooling a region of the sputter target assembly adjacent to the first textured region, by effectuating heat dissipation.

In more detail, the process begins (step S1101), and a sputter surface is generated on a sputter target (step S 1102). The sputter surface is generated on a sputter target, where the sputter surface includes a sputter area for sputtering, and at least a first non-sputter area. The process of generating a sputter surface on a sputter target is well known in the material science art.

A backside surface is generated on a backing plate (step S1104). The backside surface is generated on the backing plate in order to increase the surface area of the backing plate and the overall target assembly. The backside surface includes at least a first textured region, where the first textured region aids in cooling a region of the sputter target adjacent to the first textured region, by effectuating heat dissipation. The backside surface also includes at least a first non-textured region.

## Claims

1. A sputter target (201) in which cooling rates are selectively controlled through surface area alteration, comprising:
a sputter surface (202); and
a backside surface (206) obverse to said sputter surface, said backside surface further comprising at least a first textured region (210);
wherein said first textured region aids in cooling a region of the sputter target adjacent to said first textured region, by effectuating heat dissipation.

2. A sputter target in which cooling rates are selectively controlled through surface area alteration according to Claim 1, wherein said backside surface (206) further comprises at least a first non-textured region (212).

3. A sputter target in which cooling rates are selectively controlled through surface area alteration according to Claim 1 or 2, wherein said sputter surface (202) further comprises:
a sputter area (204) for sputtering; and
at least a first non-sputter area (205),
wherein said first textured region (210) is obverse to said sputter area.

4. A sputter target in which cooling rates are selectively controlled through surface area alteration according to any one of the preceding claims , wherein said sputter surface (202) further comprises:
a sputter area (204) for sputtering; and
at least a first non-sputter area (205),
wherein said first textured region (210) is obverse to said first non-sputter area.

5. A sputter target in which cooling rates are selectively controlled through surface area alteration according to any one of the preceding claims, wherein said sputter target (201) is comprised of a metal alloy.

6. A sputter target in which cooling rates are selectively controlled through surface area alteration according to any one of claims 1-4, wherein said sputter target (201) is comprised of a ceramic material.

7. A sputter target in which cooling rates are selectively controlled through surface area alteration according to any one of the preceding claims, wherein the first textured region (210) protrudes from said backside surface.

8. A sputter target in which cooling rates are selectively controlled through surface area alteration according to any one of claims 1-6, wherein the first textured region (210) cuts into said backside surface.

9. A sputter target in which cooling rates are selectively controlled through surface area alteration according to any one of the preceding claims, wherein said first textured region (210) is textured with a random texture.

10. A sputter target in which cooling rates are selectively controlled through surface area alteration according to Claim 9, wherein the random texture is grit blasting.

11. A sputter target in which cooling rates are selectively controlled through surface area alteration according to Claim 9, wherein the random texture is random machining.

12. A sputter target in which cooling rates are selectively controlled through surface area alteration according to any one of the preceding claims, wherein the first textured region (210) is textured with cross-hatches.

13. A sputter target in which cooling rates are selectively controlled through surface area alteration according to any one of claims 1-11, wherein the first textured region (210) is textured with concentric circles.

14. A sputter target in which cooling rates are selectively controlled through surface area alteration according to any one of claims 1-11, wherein the first textured region (210) is textured with rectangular shapes.

15. A sputter target in which cooling rates are selectively controlled through surface area alteration according to any one of claims 1-11, wherein the first textured region (210) is textured with parallel lines

16. A sputter target in which cooling rates are selectively controlled through surface area alteration according to any one of claims 1-11, wherein the first textured (210) region is textured with curved lines.

17. A sputter target in which cooling rates are selectively controlled through surface area alteration according to Claim 16, wherein the curved lines facilitate rapid flow of a cooling fluid which is in contact with said backside surface (206).

18. A sputter target in which cooling rates are selectively controlled through surface area alteration according to Claim 16, wherein the curved lines facilitate turbulent flow of a cooling fluid which is in contact with said backside surface (206).

19. A sputter target in which cooling rates are selectively controlled through surface area alteration according to any one of the preceding claims, wherein said sputter target (201) is circular.

20. A sputter target in which cooling rates are selectively controlled through surface area alteration according to any one of claims 1-19, wherein said sputter target (201) is rectangular.

21. A sputter target in which cooling rates are selectively controlled through surface area alteration according to any one of claims 1-19, wherein said sputter target (201) is hexagonal.

22. A method for manufacturing a sputter target (201) in which cooling rates are selectively controlled through surface area alteration, comprising the steps of:
generating (S902) a sputter surface (202); and
generating (S904) a backside surface (206) obverse to the sputter surface, wherein the backside surface includes at least a first textured region (210),
wherein the first textured region aids in cooling a region of the sputter target adjacent to said first textured region, by effectuating heat dissipation.

23. A method for manufacturing a sputter target assembly (1001) in which cooling rates are selectively controlled through surface area alteration, comprising the steps of:
generating (S1102) a sputter surface on a sputter target (1014);
generating (S1104) a backside surface (1006) on a backing plate (1015), wherein the backside surface includes at least a first textured region (1010); and
bonding (S1105) the sputter target and the backing plate together, so that the sputter surface is obverse to the backside surface,
wherein the first textured region aids in cooling a region of the sputter target assembly adjacent to the first textured region, by effectuating heat dissipation.

24. A method according to Claim 22 or 23, wherein the backside surface (210, 1010) further includes at least a first non-textured region.

25. A method according to any one of claims 22-24, wherein the first textured region (210, 1010) is generated using grit blasting.

26. A method according to any one of claims 22-24, wherein the first textured region (210, 1010) is generated using random machining.

27. A method according to any one of claims 22-24, wherein the first textured region (210, 1010) is generated using a lathe.

28. A method according to any one of claims 22-24, wherein the first textured region (210, 1010) is generated using laser ablation.

29. A sputter target assembly (1001) in which cooling rates are selectively controlled through surface area alteration, comprising:
a sputter target (1014) further comprising a sputter surface (1002); and
a backing plate (1015) further comprising a backside surface (1006), said backside surface further comprising at least a first textured region (1010),
wherein said sputter target and said backing plate are bonded together, so that said sputter surface is obverse to said backside surface, and
wherein said first textured region aids in cooling a region of the sputter target assembly adjacent to said first textured region, by effectuating heat dissipation.

30. A sputter target assembly in which cooling rates are selectively controlled through surface area alteration according to Claim 29, wherein said backside surface (1006) further comprises at least a first non-textured region (1012).

31. A sputter target assembly in which cooling rates are selectively controlled through surface area alteration according to Claim 29 or 30, wherein said sputter surface (1002) further comprises:
a sputter area (1004) for sputtering; and
at least a first non-sputter area (1005),
wherein said first textured region (1010) is obverse to said sputter area.

32. A sputter target assembly in which cooling rates are selectively controlled through surface area alteration according to any one of claims 29-31, wherein said sputter surface (1002) further comprises:
a sputter area (1004) for sputtering; and
at least a first non-sputter area (1012),
wherein said first textured region (1010) is obverse to said first non-sputter area.

33. A sputter target assembly in which cooling rates are selectively controlled through surface area alteration according to any one of claims 29-32, wherein said sputter target (1014) is comprised of a metal alloy.

34. A sputter target assembly in which cooling rates are selectively controlled through surface area alteration according to any one of claims 29-32, wherein said sputter target (1014)is comprised of a ceramic material.

35. A sputter target assembly in which cooling rates are selectively controlled through surface area alteration according to any one of claims 29-34, wherein the first textured region (1010) protrudes from said backside surface (1006).

36. A sputter target assembly in which cooling rates are selectively controlled through surface area alteration according to any one of claims 29-34, wherein the first textured region (1010) cuts into said backside surface (1006).

37. A sputter target assembly in which cooling rates are selectively controlled through surface area alteration according to any one of claims 29-36, wherein said first textured region (1010) is textured with a random texture.

38. A sputter target assembly in which cooling rates are selectively controlled through surface area alteration according to Claim 37, wherein the random texture is grit blasting.

39. A sputter target assembly in which cooling rates are selectively controlled through surface area alteration according to Claim 37, wherein the random texture is random machining.

40. A sputter target assembly in which cooling rates are selectively controlled through surface area alteration according to any one of claims 29-39, wherein the first textured region (1010) is textured with cross-hatches.

41. A sputter target assembly in which cooling rates are selectively controlled through surface area alteration according to any one of claims 29-39, wherein the first textured region (1010) is textured with concentric circles.

42. A sputter target assembly in which cooling rates are selectively controlled through surface area alteration according to any one of claims 29-39, wherein the first textured region (1010) is textured with rectangular shapes.

43. A sputter target assembly in which cooling rates are selectively controlled through surface area alteration according to any one of claims 29-39, wherein the first textured region (1010) is textured with parallel lines

44. A sputter target assembly in which cooling rates are selectively controlled through surface area alteration according to any one of claims 29-39, wherein the first textured region (1010) is textured with curved lines.

45. A sputter target assembly in which cooling rates are selectively controlled through surface area alteration according to Claim 44, wherein the curved lines facilitate rapid flow of a cooling fluid which is in contact with said backside surface (1006).

46. A sputter target assembly in which cooling rates are selectively controlled through surface area alteration according to Claim 44, wherein the curved lines facilitate turbulent flow of a cooling fluid which is in contact with said backside surface (1006).

47. A sputter target assembly in which cooling rates are selectively controlled through surface area alteration according to any one of claims 29-46, wherein said sputter target (1014) is circular.

48. A sputter target assembly in which cooling rates are selectively controlled through surface area alteration according to any one of claims 29-46, wherein said sputter target (1014) is rectangular.

49. A sputter target assembly in which cooling rates are selectively controlled through surface area alteration according to any one of claims 29-46, wherein said sputter target (1014) is hexagonal.

## Patentansprüche

1. Zerstäubertarget bzw. Sputtertarget (201), in welchem Kühlgeschwindigkeiten bzw. -raten selektiv durch eine Oberflächen-Flächenveränderung gesteuert bzw. geregelt sind bzw. werden, umfassend:
eine Zerstäubungs- bzw. Zerstäuberoberfläche (202); und
eine Rückseitenoberfläche (206) abgewandt von der Zerstäuberoberfläche, wobei die Rückseitenoberfläche weiterhin wenigstens einen ersten texturierten Bereich (210) umfaßt;
wobei der erste texturierte Bereich beim Kühlen eines Bereichs bzw. einer Region des Zerstäubertargets benachbart dem ersten texturierten Bereich hilft, indem eine Wärmeverteilung bewirkt ist bzw. wird.

2. Zerstäubertarget, in welchem Kühlgeschwindigkeiten bzw. -raten selektiv durch eine Oberflächen-Flächenveränderung gesteuert bzw. geregelt sind, nach Anspruch 1, wobei die Rückseitenoberfläche (206) weiterhin wenigstens einen ersten nicht texturierten Bereich (212) umfaßt.

3. Zerstäubertarget, in welchem Kühlgeschwindigkeiten selektiv durch eine Oberflächen-Flächenveränderung gesteuert bzw. geregelt sind, nach Anspruch 1 oder 2, wobei die Zerstäuberoberfläche (202) weiterhin umfaßt:
eine Zerstäuberfläche (204) zum Zerstäuben; und
wenigstens eine Nicht-Zerstäuberfläche (205),
wobei der erste texturierte Bereich (210) abgewandt von der Zerstäuberfläche ist.

4. Zerstäubertarget, in welchem Kühlgeschwindigkeiten bzw. -raten selektiv durch eine Oberflächen-Flächenveränderung gesteuert bzw. geregelt sind, nach einem der vorhergehenden Ansprüche, wobei die Zerstäuberoberfläche (202) weiterhin umfaßt:
eine Zerstäuberfläche (204) zum Zerstäuben ; und
wenigstens eine Nicht-Zerstäuberfläche (205),
wobei der erste texturierte Bereich (210) abgewandt von der ersten Nicht-Zerstäuberfläche ist.

5. Zerstäubertarget, in welchem Kühlgeschwindigkeiten selektiv durch eine Oberflächen-Flächenveränderung gesteuert bzw. geregelt sind, nach einem der vorhergehenden Ansprüche, wobei das Zerstäubertarget (201) eine Metallegierung umfasst.

6. Zerstäubertarget, in welchem Kühlgeschwindigkeiten selektiv durch eine Oberflächen-Flächenveränderung gesteuert bzw. geregelt sind, nach einem der Ansprüche 1-4, wobei das Zerstäubertarget (201) aus einem Keramikmaterial besteht.

7. Zerstäubertarget, in welchem Kühlgeschwindigkeiten selektiv durch eine Oberflächen-Flächenveränderung gesteuert bzw, geregelt sind, nach einem der vorhergehenden Ansprüche, wobei der erste texturierte Bereich (210) von der Rückseitenoberfläche vorragt.

8. Zerstäubertarget, in welchem Kühlgeschwindigkeiten selektiv durch eine Oberflächen-Flächenveränderung gesteuert bzw. geregelt sind, nach einem der Ansprüche 1-6, wobei der erste texturierte Bereich (210) in die Rückseitenoberfläche einschneidet.

9. Zerstäubertarget, in welchem Kühlgeschwindigkeiten selektiv durch eine Oberflächen-Flächenveränderung gesteuert bzw. geregelt sind, nach einem der vorhergehenden Ansprüche, wobei der erste texturierte Bereich (210) mit einer statistischen bzw. zufälligen Textur texturiert ist.

10. Zerstäubertarget, in welchem Kühlgeschwindigkeiten selektiv durch eine Oberflächen-Flächenveränderung gesteuert bzw. geregelt sind, nach Anspruch 9, wobei die zufällige Textur Sandstrahlen ist.

11. Zerstäubertarget, in welchem Kühlgeschwindigkeiten selektiv durch eine Oberflächen-Flächenveränderung gesteuert bzw. geregelt sind, nach Anspruch 9, wobei die zufällige Textur ein zufälliges Bearbeiten ist.

12. Zerstäubertarget, in welchem Kühlgeschwindigkeiten selektiv durch eine Oberflächen-Flächenveränderung gesteuert bzw. geregelt sind, nach einem der vorhergehenden Ansprüche, wobei der erste texturierte Bereich (210) mit Querschraffierungen texturiert ist.

13. Zerstäubertarget, in welchem Kühlgeschwindigkeiten selektiv durch eine Oberflächen-Flächenveränderung gesteuert bzw. geregelt sind, nach einem der Ansprüche 1-11, wobei der erste texturierte Bereich (210) mit konzentrischen Kreisen texturiert ist.

14. Zerstäubertarget, in welchem Kühlgeschwindigkeiten selektiv durch eine Oberflächen-Flächenveränderung gesteuert bzw. geregelt sind, nach einem der Ansprüche 1-11, wobei der erste texturierte Bereich (210) mit rechteckigen bzw. rechtwinkeligen Formen texturiert ist.

15. Zerstäubertarget, in welchem Kühlgeschwindigkeiten selektiv durch eine Oberflächen-Flächenveränderung gesteuert bzw. geregelt sind, nach einem der Ansprüche 1-11, wobei der erste texturierte Bereich (210) mit parallelen Linien texturiert ist.

16. Zerstäubertarget, in welchem Kühlgeschwindigkeiten selektiv durch eine Oberflächen-Flächenveränderung gesteuert bzw. geregelt sind, nach einem der Ansprüche 1-11, wobei der erste texturierte Bereich (210) mit gekrümmten Linien texturiert ist.

17. Zerstäubertarget, in welchem Kühlgeschwindigkeiten selektiv durch eine Oberflächen-Flächenveränderung gesteuert bzw. geregelt sind, nach Anspruch 16, wobei die gekrümmten Linien einen schnellen Fluß eines Kühlfluids erleichtern, welches in Kontakt mit der Rückseitenoberfläche (206) ist.

18. Zerstäubertarget, in welchem Kühlgeschwindigkeiten selektiv durch eine Oberflächen-Flächenveränderung gesteuert bzw. geregelt sind, nach Anspruch 16, wobei die gekrümmten Linien einen turbulenten bzw. Wirbelstrom eines Kühlfluids erleichtern, welches in Kontakt mit der Rückseitenoberfläche (206) ist.

19. Zerstäubertarget, in welchem Kühlgeschwindigkeiten selektiv durch eine Oberflächen-Flächenveränderung gesteuert bzw. geregelt sind, nach einem der vorhergehenden Ansprüche, wobei das Zerstäubertarget (201) kreisförmig ist.

20. Zerstäubertarget, in welchem Kühlgeschwindigkeiten selektiv durch eine Oberflächen-Flächenveränderung gesteuert bzw. geregelt sind, nach einem der Ansprüche 1-19, wobei das Zerstäubertarget (201) rechteckig ist.

21. Zerstäubertarget, in welchem Kühlgeschwindigkeiten selektiv durch eine Oberflächen-Flächenveränderung gesteuert bzw. geregelt sind, nach einem der Ansprüche 1-19, wobei das Zerstäubertarget (201) hexagonal bzw. sechseckig ist.

22. Verfahren zum Herstellen eines Zerstäubertargets (201), in welchem Kühlgeschwindigkeiten bzw. -raten selektiv durch eine Oberflächen-Flächenveränderung gesteuert bzw. geregelt werden, umfassend die Schritte:
Generieren bzw. Erzeugen (S902) einer Sputter- bzw. Zerstäubungs- bzw. Zerstäuberoberfläche (202); und
Generieren (S904) einer Rückseitenoberfläche (206) abgewandt von der Sputteroberfläche, wobei die Rückseitenoberfläche wenigstens einen ersten texturierten Bereich (210) beinhaltet,
wobei der erste texturierte Bereich beim Kühlen eines Bereichs bzw. einer Region des Zerstäubertargets benachbart dem ersten texturierten Bereich durch ein Bewirken einer Wärmeverteilung bzw. -dissipation hilft.

23. Verfahren zur Herstellung einer Zerstäubertargetanordnung (1001), in welcher Kühlgeschwindigkeiten bzw. -raten selektiv durch eine Oberflächen-Flächenveränderung gesteuert bzw. geregelt werden, umfassend die Schritte:
Generieren (S1102) einer Sputter- bzw. Zerstäuberoberfläche auf einem Sputter- bzw. Zerstäubertarget (1014);
Generieren (S1104) einer Rückseitenobertläche (1006) auf einer abstützenden bzw. Rückseitenplatte (1015), wobei die Rückseitenoberfläche wenigstens einen ersten texturierten Bereich (1010) beinhaltet; und
Bonden (S1105) des Zerstäubertargets und der Rückseitenplatte aneinander, so daß die Zerstäuberoberfläche der Rückseitenoberfläche abgewandt ist,
wobei der erste texturierte Bereich beim Kühlen eines Bereichs bzw. einer Region der Zerstäubertargetanordnung benachbart dem ersten texturierten Bereich durch ein Bewirken einer Wärmeverteilung bzw. -dissipation hilft.

24. Verfahren nach Anspruch 22 oder 23, wobei die Rückseitenoberfläche (210, 1010) weiterhin einen ersten nicht texturierten Bereich umfaßt.

25. Verfahren nach einem der Ansprüche 22-24, wobei der erste texturierte Bereich (210, 1010) unter Verwendung eines Sandstrahlens generiert bzw. erzeugt wird.

26. Verfahren nach einem der Ansprüche 22-24, wobei der erste texturierte Bereich (210, 1010) unter Verwendung einer zufälligen bzw. statistischen Bearbeitung generiert wird.

27. Verfahren nach einem der Ansprüche 22-24, wobei der erste texturierte Bereich (210, 1010) unter Verwendung einer Drehbank generiert wird.

28. Verfahren nach einem der Ansprüche 22-24, wobei der erste texturierte Bereich (210, 1010) unter Verwendung einer Laserablation generiert wird.

29. Zerstäuber- bzw. Sputtertargetanordnung (1001), in welcher Kühlgeschwindigkeiten bzw. -raten selektiv durch eine Oberflächen-Flächenveränderung gesteuert bzw. geregelt sind, umfassend:
ein Zerstäuber- bzw. Sputtertarget (1014), weiterhin umfassend eine Zerstäuber- bzw. Sputteroberfläche (1002); und
eine Rückseitenplatte (1015), weiterhin umfassend eine Rückseitenoberfläche (1006), wobei die Rückseitenoberfläche weiterhin wenigstens einen ersten texturierten Bereich (1010) umfaßt;
wobei das Zerstäubertarget und die Rückseitenplatte miteinander verbunden bzw. gebondet sind, so daß die Sputteroberfläche der Rückseitenoberfläche abgewandt ist, und
wobei der erste texturierte Bereich beim Kühlen eines Bereichs bzw. einer Region der Zerstäubertargetanordnung benachbart dem ersten texturierten Bereich hilft, indem eine Wärmeverteilung bzw. -dissipation bewirkt ist bzw. wird.

30. Zerstäubertargetanordnung, in welcher Kühlgeschwindigkeiten selektiv durch eine Oberflächen-Flächenveränderung gesteuert bzw. geregelt sind, nach Anspruch 29, wobei die Rückseitenoberfläche (1006) weiterhin wenigstens einen ersten nicht texturierten Bereich (1012) umfaßt.

31. Zerstäubertargetanordnung, in welcher Kühlgeschwindigkeiten selektiv durch eine Oberflächen-Flächenveränderung gesteuert bzw. geregelt sind, nach Anspruch 29 oder 30, wobei die Zerstäuberoberfläche (1002) weiterhin umfaßt:
eine Zerstäuberfläche (1004) zum Zerstäuben; und
wenigstens eine erste Nicht-Zerstäuberfläche (1005),
wobei der erste texturierte Bereich (1010) der Zerstäuberfläche abgewandt ist.

32. Zerstäubertargetanordnung, in welcher Kühlgeschwindigkeiten selektiv durch eine Oberflächen-Flächenveränderung gesteuert bzw. geregelt sind, nach einem der Ansprüche 29-31, wobei die Zerstäuberoberfläche (1002) weiterhin umfaßt:
eine Zerstäuberfläche (1004) zum Zerstäuben; und
wenigstens eine Nicht-Zerstäuberfläche (1012),
wobei der erste texturierte Bereich (1010) der ersten Nicht-Zerstäuberfläche abgewandt ist.

33. Zerstäubertargetanordnung, in welcher Kühlgeschwindigkeiten selektiv durch eine Oberflächen-Flächenveränderung gesteuert bzw. geregelt sind, nach einem der Ansprüche 29-32, wobei das Zerstäubertarget (1014) eine Metallegierung umfasst.

34. Zerstäubertargetanordnung, in welcher Kühlgeschwindigkeiten selektiv durch eine Oberflächen-Flächenveränderung gesteuert bzw, geregelt sind, nach einem der Ansprüche 29-32, wobei das Zerstäubertarget (1014) aus einem keramischen Material besteht.

35. Zerstäubertargetanordnung, in welcher Kühlgeschwindigkeiten selektiv durch eine Oberflächen-Flächenveränderung gesteuert bzw. geregelt sind, nach einem der Ansprüche 29-34, wobei der erste texturierte Bereich (1010) von der Rückseitenoberfläche (1006) vorragt.

36. Zerstäubertargetanordnung, in welcher Kühlgeschwindigkeiten selektiv durch eine Oberflächen-Flächenveränderung gesteuert bzw. geregelt sind, nach einem der Ansprüche 29-34, wobei der erste texturierte Bereich (1010) in die Rückseitenoberfläche (1006) einschneidet.

37. Zerstäubertargetanordnung, in welcher Kühlgeschwindigkeiten selektiv durch eine Oberflächen-Flächenveränderung gesteuert bzw. geregelt sind, nach einem der Ansprüche 29-36, wobei der erste texturierte Bereich (1010) mit einer zufälligen Textur texturiert ist.

38. Zerstäubertargetanordnung, in welcher Kühlgeschwindigkeiten selektiv durch eine Oberflächen-Flächenveränderung gesteuert bzw. geregelt sind, nach Anspruch 37, wobei die zufällige Textur Sandstrahlen ist.

39. Zerstäubertargetanordnung, in welcher Kühlgeschwindigkeiten selektiv durch eine Oberfilächen-Flächenveränderung gesteuert bzw. geregelt sind, nach Anspruch 37, wobei die zufällige Textur ein zufälliges Bearbeiten ist.

40. Zerstäubertargetanordnung, in welcher Kühlgeschwindigkeiten selektiv durch eine Oberflächen-Flächenveränderung gesteuert bzw. geregelt sind, nach einem der Ansprüche 29-39, wobei der erste texturierte Bereich (1010) mit Quer- bzw. Kreuzschraffierungen texturiert ist.

41. Zerstäubertargetanordnung, in welcher Kühlgeschwindigkeiten selektiv durch eine Oberflächen-Flächenveränderung gesteuert bzw. geregelt sind, nach einem der Ansprüche 29-39, wobei der erste texturierte Bereich (1010) mit konzentrischen Kreisen texturiert ist.

42. Zerstäubertargetanordnung, in welcher Kühlgeschwindigkeiten selektiv durch eine Oberflächen-Flächenveränderung gesteuert bzw. geregelt sind, nach einem der Ansprüche 29-39, wobei der erste texturierte Bereich (1010) mit rechteckigen Formen texturiert ist.

43. Zerstäubertargetanordnung, in welcher Kühlgeschwindigkeiten selektiv durch eine Oberflächen-Flächenveränderung gesteuert bzw. geregelt sind, nach einem der Ansprüche 29-39, wobei der erste texturierte Bereich (1010) mit parallelen Linien texturiert ist.

44. Zerstäubertargetanordnung, in welcher Kühlgeschwindigkeiten selektiv durch eine Oberflächen-Flächenveränderung gesteuert bzw. geregelt sind, nach einem der Ansprüche 29-39, wobei der erste texturierte Bereich (1010) mit gekrümmten Linien texturiert ist.

45. Zerstäubertargetanordnung, in welcher Kühlgeschwindigkeiten selektiv durch eine Oberflächen-Flächenveränderung gesteuert bzw. geregelt sind, nach Anspruch 44, wobei die gekrümmten Linien einen schnellen Fluß eines Kühlfluids erleichtern, welches in Kontakt mit der Rückseitenoberfläche (1006) ist.

46. Zerstäubertargetanordnung, in welcher Kühlgeschwindigkeiten selektiv durch eine Oberflächen-Flächenveränderung gesteuert bzw. geregelt sind, nach Anspruch 44, wobei die gekrümmten Linien einen turbulenten Strom eines Kühlfluids erleichtern, welches in Kontakt mit der Rückseitenoberfläche (1006) ist.

47. Zerstäubertargetanordnung, in welcher Kühlgeschwindigkeiten selektiv durch eine Oberflächen-Flächenveränderung gesteuert bzw. geregelt sind, nach einem der Ansprüche 29-46, wobei das Sputter- bzw, Zerstäubertarget (1014) kreisförmig ist.

48. Zerstäubertargetanordnung, in welcher Kühlgeschwindigkeiten selektiv durch eine Oberflächen-Flächenveränderung gesteuert bzw. geregelt sind, nach einem der Ansprüche 29-46, wobei das Zerstäubertarget (1014) rechteckig ist.

49. Zerstäubertargetanordnung, in welcher Kühlgeschwindigkeiten selektiv durch eine Oberflächen-Flächenveränderung gesteuert bzw. geregelt sind, nach einem der Ansprüche 29-46, wobei das Zerstäubertarget (1014) hexagonal bzw, sechseckig ist.

## Revendications

1. Cible de pulvérisation (201) dans laquelle les vitesses de refroidissement sont contrôlées de façon sélective au moyen de l'altération de la surface, comprenant :
une surface de pulvérisation (202) ; et
une surface arrière (206) opposée à ladite surface de pulvérisation, ladite surface arrière comprenant en outre au moins une première région texturée (210) ;
**caractérisée en ce que** ladite première région texturée aide à refroidir une région de la cible de pulvérisation adjacente à ladite première région texturée, en effectuant une dissipation de chaleur.

2. Cible de pulvérisation dans laquelle les vitesses de refroidissement sont contrôlées de façon sélective au moyen de l'altération de la surface selon la revendication 1, dans laquelle ladite surface arrière (206) comprend en outre au moins une première région non texturée (212).

3. Cible de pulvérisation dans laquelle les vitesses de refroidissement sont contrôlées de façon sélective au moyen de l'altération de la surface selon la revendication 1 ou 2, dans laquelle ladite surface de pulvérisation (202) comprend en outre :
une zone de pulvérisation (204) pour la pulvérisation ; et
au moins une première zone de non pulvérisation (205),
dans laquelle ladite première région texturée (210) est opposée à ladite zone de pulvérisation.

4. Cible de pulvérisation dans laquelle les vitesses de refroidissement sont contrôlées de façon sélective au moyen de l'altération de la surface selon l'une quelconque des revendications précédentes, dans laquelle ladite surface de pulvérisation (202) comprend en outre :
une zone de pulvérisation (204) pour la pulvérisation ; et
au moins une première zone de non pulvérisation (205),
dans laquelle ladite première région texturée (210) est opposée à ladite zone de non pulvérisation.

5. Cible de pulvérisation dans laquelle les vitesses de refroidissement sont contrôlées de façon sélective au moyen de l'altération de la surface selon l'une quelconque des revendications précédentes, dans laquelle ladite cible de pulvérisation (201) est constituée d'un alliage de métal.

6. Cible de pulvérisation dans laquelle les vitesses de refroidissement sont contrôlées de façon sélective au moyen de l'altération de la surface selon l'une quelconque des revendications 1 à 4, dans laquelle ladite cible de pulvérisation (201) est constituée d'un matériau céramique.

7. Cible de pulvérisation dans laquelle les vitesses de refroidissement sont contrôlées de façon sélective au moyen de l'altération de la surface selon l'une quelconque des revendications précédentes, dans laquelle la première région texturée (210) fait saillie à partir de ladite surface arrière.

8. Cible de pulvérisation dans laquelle les vitesses de refroidissement sont contrôlées de façon sélective au moyen de l'altération de la surface selon l'une quelconque des revendications 1 à 6, dans laquelle la première région texturée (210) coupe ladite surface arrière.

9. Cible de pulvérisation dans laquelle les vitesses de refroidissement sont contrôlées de façon sélective au moyen de l'altération de la surface selon l'une quelconque des revendications précédentes, dans laquelle ladite première région texturée (210) est texturée par une texture aléatoire.

10. Cible de pulvérisation dans laquelle les vitesses de refroidissement sont contrôlées de façon sélective au moyen de l'altération de la surface selon la revendication 9, dans laquelle la texture aléatoire est faite par jet d'abrasif.

11. Cible de pulvérisation dans laquelle les vitesses de refroidissement sont contrôlées de façon sélective au moyen de l'altération de la surface selon la revendication 9, dans laquelle la texture aléatoire est faite par usinage aléatoire.

12. Cible de pulvérisation dans laquelle les vitesses de refroidissement sont contrôlées de façon sélective au moyen de l'altération de la surface selon l'une quelconque des revendications précédentes, dans laquelle la première région texturée (210) est texturée avec des hachures.

13. Cible de pulvérisation dans laquelle les vitesses de refroidissement sont contrôlées de façon sélective au moyen de l'altération de la surface selon l'une quelconque des revendications 1 à 11, dans laquelle la première région texturée (210) est texturée avec des cercles concentriques.

14. Cible de pulvérisation dans laquelle les vitesses de refroidissement sont contrôlées de façon sélective au moyen de l'altération de la surface selon l'une quelconque des revendications 1 à 11, dans laquelle la première région texturée (210) est texturée avec des formes rectangulaires.

15. Cible de pulvérisation dans laquelle les vitesses de refroidissement sont contrôlées de façon sélective au moyen de l'altération de la surface selon l'une quelconque des revendications 1 à 11, dans laquelle la première région texturée (210) est texturée avec des lignes parallèles.

16. Cible de pulvérisation dans laquelle les vitesses de refroidissement sont contrôlées de façon sélective au moyen de l'altération de la surface selon l'une quelconque des revendications 1 à 11, dans laquelle la première région texturée (210) est texturée avec des lignes courbes.

17. Cible de pulvérisation dans laquelle les vitesses de refroidissement sont contrôlées de façon sélective au moyen de l'altération de la surface selon la revendication 16, dans laquelle les lignes courbes facilitent un écoulement rapide d'un fluide de refroidissement qui est en contact avec ladite surface arrière (206).

18. Cible de pulvérisation dans laquelle les vitesses de refroidissement sont contrôlées de façon sélective au moyen de l'altération de la surface selon la revendication 16, dans laquelle lignes courbes facilitent un écoulement turbulent d'un fluide de refroidissement qui est en contact avec ladite surface arrière (206).

19. Cible de pulvérisation dans laquelle les vitesses de refroidissement sont contrôlées de façon sélective au moyen de l'altération de la surface selon l'une quelconque des revendications précédentes, dans laquelle ladite cible de pulvérisation (201) est circulaire.

20. Cible de pulvérisation dans laquelle les vitesses de refroidissement sont contrôlées de façon sélective au moyen de l'altération de la surface selon l'une quelconque des revendications 1 à 19, dans laquelle ladite cible de pulvérisation (201) est rectangulaire.

21. Cible de pulvérisation dans laquelle les vitesses de refroidissement sont contrôlées de façon sélective au moyen de l'altération de la surface selon l'une quelconque des revendications 1 à 19, dans laquelle ladite cible de pulvérisation (201) est hexagonale.

22. Procédé de fabrication d'une cible de pulvérisation (201) dans laquelle les vitesses de refroidissement sont contrôlées de façon sélective au moyen de l'altération de la surface, comprenant les étapes consistant à :
générer (S902) une surface de pulvérisation (202) ; et
générer (S904) une surface arrière (206) opposée à la surface de pulvérisation, dans lequel la surface arrière comprend au moins une première région texturée (210),
dans lequel la première région texturée aide à refroidir une région de la cible de pulvérisation adjacente à ladite première région texturée, en effectuant une dissipation de chaleur.

23. Procédé de fabrication d'un assemblage de cible de pulvérisation (1001) dans lequel les vitesses de refroidissement sont contrôlées de façon sélective au moyen de l'altération de la surface, comprenant les étapes consistant à :
générer (S1102) une surface de pulvérisation sur une cible de pulvérisation (1014) ;
générer (S1104) une surface arrière (1006) sur une contre-plaque (1015), dans lequel la surface arrière comprend au moins une première région texturée (1010) ; et
lier (S1105) ensemble la cible de pulvérisation et la contre-plaque, de façon que la surface de pulvérisation soit opposée à la surface arrière,
dans lequel la première région texturée aide à refroidir une région de la cible de pulvérisation adjacente à ladite première région texturée, en effectuant une dissipation de chaleur.

24. Procédé selon la revendication 22 ou 23, dans lequel la surface arrière (210, 1010) comprend en outre au moins une première région non texturée.

25. Procédé selon l'une quelconque des revendications 22 à 24, dans lequel la première région texturée (210, 1010) est générée en utilisant un jet d'abrasif.

26. Procédé selon l'une quelconque des revendications 22 à 24, dans lequel la première région texturée (210, 1010) est générée en utilisant un usinage aléatoire.

27. Procédé selon l'une quelconque des revendications 22 à 24, dans lequel la première région texturée (210, 1010) est générée en utilisant un tour.

28. Procédé selon l'une quelconque des revendications 22 à 24, dans lequel la première région texturée (210, 1010) est générée en utilisant une ablation au laser.

29. Assemblage de cible de pulvérisation (1001) dans lequel les vitesses de refroidissement sont contrôlées de façon sélective au moyen de l'altération de la surface, comprenant :
une cible de pulvérisation (1014) comprenant en outre une surface de pulvérisation (1002) ; et
une contre-plaque (1015) comprenant en outre une surface arrière (1006), ladite surface arrière comprenant en outre au moins une première région texturée (1010),
dans lequel ladite cible de pulvérisation et ladite contre-plaque sont liées ensemble, de façon que ladite surface de pulvérisation soit opposée à ladite surface arrière, et
dans lequel ladite première région texturée aide à refroidir une région de l'assemblage de cible de pulvérisation adjacente à ladite première région texturée, en effectuant une dissipation de chaleur.

30. Assemblage de cible de pulvérisation dans lequel les vitesses de refroidissement sont contrôlées de façon sélective au moyen de l'altération de la surface selon la revendication 29, dans lequel ladite surface arrière (1006) comprend en outre au moins une première région non texturée (1012).

31. Assemblage de cible de pulvérisation dans lequel les vitesses de refroidissement sont contrôlées de façon sélective au moyen de l'altération de la surface selon la revendication 29 ou 30, dans lequel ladite surface de pulvérisation (1002) comprend en outre :
une zone de pulvérisation (1004) pour la pulvérisation ; et
au moins une première zone de non pulvérisation (1005),
dans lequel ladite première région texturée (1010) est opposée à ladite zone de pulvérisation.

32. Assemblage de cible de pulvérisation dans lequel les vitesses de refroidissement sont contrôlées de façon sélective au moyen de l'altération de la surface selon l'une quelconque des revendications 29 à 31, dans lequel ladite surface de pulvérisation (1002) comprend en outre :
une zone de pulvérisation (1004) pour la pulvérisation ; et
au moins une première zone de non pulvérisation (1012),
dans lequel ladite première région texturée (1010) est opposée à ladite zone de non pulvérisation.

33. Assemblage de cible de pulvérisation dans lequel les vitesses de refroidissement sont contrôlées de façon sélective au moyen de l'altération de la surface selon l'une quelconque des revendications 29 à 32, dans lequel ladite surface de pulvérisation (1014) est constituée d'un alliage de métal.

34. Assemblage de cible de pulvérisation dans lequel les vitesses de refroidissement sont contrôlées de façon sélective au moyen de l'altération de la surface selon l'une quelconque des revendications 29 à 32, dans lequel ladite surface de pulvérisation (1014) est constituée d'un matériau céramique.

35. Assemblage de cible de pulvérisation dans lequel les vitesses de refroidissement sont contrôlées de façon sélective au moyen de l'altération de la surface selon l'une quelconque des revendications 29 à 34, dans lequel la première région texturée (1010) fait saillie à partir de ladite surface arrière (1006).

36. Assemblage de cible de pulvérisation dans lequel les vitesses de refroidissement sont contrôlées de façon sélective au moyen de l'altération de la surface selon l'une quelconque des revendications 29 à 34, dans lequel la première région texturée. (1010) coupe ladite surface arrière (1006).

37. Assemblage de cible de pulvérisation dans lequel les vitesses de refroidissement sont contrôlées de façon sélective au moyen de l'altération de la surface selon l'une quelconque des revendications 29 à 36, dans lequel la première région texturée (1010) est texturée avec une texture aléatoire.

38. Assemblage de cible de pulvérisation dans lequel les vitesses de refroidissement sont contrôlées de façon sélective au moyen de l'altération de la surface selon la revendication 37, dans lequel la première région texturée est faite par jet d'abrasif.

39. Assemblage de cible de pulvérisation dans lequel les vitesses de refroidissement sont contrôlées de façon sélective au moyen de l'altération de la surface selon la revendication 37, dans lequel la première région texturée est faite par usinage aléatoire.

40. Assemblage de cible de pulvérisation dans lequel les vitesses de refroidissement sont contrôlées de façon sélective au moyen de l'altération de la surface selon l'une quelconque des revendications 29 à 39, dans lequel la première région texturée (1010) est texturée avec des hachures.

41. Assemblage de cible de pulvérisation dans lequel les vitesses de refroidissement sont contrôlées de façon sélective au moyen de l'altération de la surface selon l'une quelconque des revendications 29 à 39, dans lequel la première région texturée (1010) est texturée avec des cercles concentriques.

42. Assemblage de cible de pulvérisation dans lequel les vitesses de refroidissement sont contrôlées de façon sélective au moyen de l'altération de la surface selon l'une quelconque des revendications 29 à 39, dans lequel la première région texturée (1010) est texturée avec des formes rectangulaires.

43. Assemblage de cible de pulvérisation dans lequel les vitesses de refroidissement sont contrôlées de façon sélective au moyen de l'altération de la surface selon l'une quelconque des revendications 29 à 39, dans lequel la première région texturée (1010) est texturée avec des lignes parallèles.

44. Assemblage de cible de pulvérisation dans lequel les vitesses de refroidissement sont contrôlées de façon sélective au moyen de l'altération de la surface selon l'une quelconque des revendications 29 à 39, dans lequel la première région texturée (1010) est texturée avec des lignes courbes.

45. Assemblage de cible de pulvérisation dans lequel les vitesses de refroidissement sont contrôlées de façon sélective au moyen de l'altération de la surface selon la revendication 44, dans lequel les lignes courbes facilitent un écoulement rapide d'un fluide de refroidissement qui est en contact avec ladite surface arrière (1006).

46. Assemblage de cible de pulvérisation dans lequel les vitesses de refroidissement sont contrôlées de façon sélective au moyen de l'altération de la surface selon la revendication 44, dans lequel les lignes courbes facilitent un écoulement turbulent d'un fluide de refroidissement qui est en contact avec ladite surface arrière (1006).

47. Assemblage de cible de pulvérisation dans lequel les vitesses de refroidissement sont contrôlées de façon sélective au moyen de l'altération de la surface selon l'une quelconque des revendications 29 à 46, dans lequel ladite cible de pulvérisation (1014) est circulaire.

48. Assemblage de cible de pulvérisation dans lequel les vitesses de refroidissement sont contrôlées de façon sélective au moyen de l'altération de la surface selon l'une quelconque des revendications 29 à 46, dans lequel ladite cible de pulvérisation (1014) est rectangulaire.

49. Assemblage de cible de pulvérisation dans lequel les vitesses de refroidissement sont contrôlées de façon sélective au moyen de l'altération de la surface selon l'une quelconque des revendications 29 à 46, dans lequel ladite cible de pulvérisation (1014) est hexagonale.
